## Europäisches Patentamt
## European Patent Office
## Office européen des brevets

(19)

(11) Veröffentlichungsnummer: **0 320 784 B1**

(12) # EUROPÄISCHE PATENTSCHRIFT

(45) Veröffentlichungstag der Patentschrift: **22.06.94**

(51) Int. Cl.5: **H03K 17/73**

(21) Anmeldenummer: **88120489.5**

(22) Anmeldetag: **08.12.88**

(54) **Verfahren und Anordnungen zur Ansteuerung eines Abschaltthyristors.**

(30) Priorität: **12.12.87 DE 3742282**
**26.03.88 DE 3810358**

(43) Veröffentlichungstag der Anmeldung:
**21.06.89 Patentblatt 89/25**

(45) Bekanntmachung des Hinweises auf die
Patenterteilung:
**22.06.94 Patentblatt 94/25**

(84) Benannte Vertragsstaaten:
**AT BE CH DE FR GB IT LI SE**

(56) Entgegenhaltungen:
**EP-A- 0 228 226**
**EP-A- 0 243 844**
**DE-A- 3 517 467**

(73) Patentinhaber: **Asea Brown Boveri Aktiengesellschaft
Kallstadter Strasse 1
D-68309 Mannheim(DE)**

(72) Erfinder: **Fregien, Gert
Wiesental 1
D-5100 Aachen(DE)**

(74) Vertreter: **Rupprecht, Klaus, Dipl.-Ing. et al
c/o ABB Patent GmbH,
Postfach 10 03 51
D-68128 Mannheim (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services
(3.10/3.09/3.3.3)

**Beschreibung**

Die Erfindung bezieht sich auf Verfahren und Anordnungen zur Ansteuerung eines Abschaltthyristors gemäß dem Oberbegriff der Ansprüche 1 bis 4.

Ein solches Verfahren und eine solche Anordnung zur Ansteuerung eines Abschaltthyristors sind aus der DE-A-35 17 467 bekannt.

Aus der DE-A-35 17 467 ist eine Schaltungsanordnung für den Abschaltsteuerkreis eines GTO-Thyristors bekannt, mit einem Impulstransformator, dessen Sekundärwicklung über Entkopplungsdioden zwischen den Steueranschluß und die Kathode des GTO-Thyristors gelegt ist und dessen Primärwicklung während der gesamten Dauer des Abschaltvorgangs des GTO-Thyristors über ein erstes Schaltelement mit einer ersten Spannungsquelle verbunden ist. Es soll durch Verringerung der erforderlichen Spannungszeitfläche beim Impulstransformator eine kleine Streuinduktivität desselben ermöglicht werden. Dies wird dadurch erreicht, daß an die Primärwicklung des Impulstransformators eine zweite Spannungsquelle angeschlossen ist, deren Spannung über ein zweites Schaltelement der Spannung der ersten Spannungsquelle vom Beginn des Abschaltvorgangs an für eine wesentlich geringere Zeit als die Gesamtdauer des Abschaltvorganges aufgeschaltet ist.

Aus der EP-A-02 28 226 ist ein Abschaltkreis für einen GTO-Thyristor bekannt, bei dem unter Einsatz von Schaltern und einer Energiequelle bzw. mehreren Energiequellen unterschiedlicher Spannung mindestens zwei unterschiedlich hohe Gate-Ströme eingeprägt werden können, um die Ausschaltverluste des Thyristors zu reduzieren.

Zum Abschalten eines Abschaltthyristors (GTO-Thyristor, GTO) wird negativer Gatestrom benötigt. Dieser negative Gatestrom wird einer Spannungsquelle (negative Treiberspannung) über eine nicht vermeidbare bzw. unbedingt notwendige Induktivität auf das Gate eingeprägt. Während der Fallzeit des Anodenstroms weist der Gatestrom einen Wert von ca. 25% des Abschaltstromes auf. Der Anodenstrom fällt auf einen Wert von ca. 15% des Abschaltstromes ("Stromschwanz") ab. Dieser "Stromschwanz" muß durch das Gate geführt werden. Der Überschuß des Gatestromes über den Anodenstrom in dieser sogenannten "Tailzeit" (25% - 15%) fließt als negativer Kathodenstrom. Die Gate-Kathodenstrecke wird dabei im Lawinendruchbruch betrieben, was örtlich hohe Verluste im GTO zur Folge hat.

Der Überschuß des Gatestromes über den Anodenstrom wird durch den Überschuß der Druchbruchspannung der Steuerstrecke des GTO über die negative Treiberspannung nach Maßgabe der Gate-Induktivität abgebaut.

Bei einer Durchbruchspannung von z.B. 20...25V und der üblichen Treiberspannung von 15V verbleiben nur 5....10V Spannungsdifferenz zum Abmagnetisieren der Gate-Induktivität. Der Abmagnetisierungsvorgang dauert somit relativ lange und die Verluste im GTO sind unnötig groß.

Der Erfindung liegt davon ausgehend die Aufgabe zugrunde, Verfahren und Anordnung zur Ansteuerung eines Abschaltthyristors der eingangs genannten Art anzugeben, die die unnötige Steuerverlustleistung weitgehend vermeiden.

Diese Aufgabe wird in Verbindung mit den Merkmalen des Oberbegriffes erfindungsgemäß durch die im Kennzeichen der Ansprüche 1 bis 4 angegebenen Merkmale gelöst.

Die mit der Erfindung erzielbaren Vorteile bestehen insbesondere darin, daß die Wärmentwicklung im Abschaltthyristor entscheidend verringert wird. Der Abschaltthyristor kann mit verminderter Verlustleistung durch die Ansteuereinheit (Treiberstufe) betrieben werden. Auch der Leistungsbedarf der Treiberstufe nimmt deutlich ab.

Ein weiterer sehr wichtiger Vorteil der Erfindung liegt darin, daß die negative Treiberspannung der Spannungsquelle frei gewählt werden kann und nicht mehr auf Werte unterhalb von üblicherweise 20V beschränkt ist.

Die Erfindung wird nachstehend anhand der in der Zeichnung dargestellten Ausführungsbeispiele erläutert.

Es zeigen:

Fig. 1   die Zusammensetzung des Gatestromes beim Abschalten,

Fig. 2   idealisierte Strom- und Spannungsverläufe am Gate eines GTO,

Fig. 3   den Steuerleistungsbedarf in Abhängigkeit vom abgeschalteten Strom,

Fig. 4   die Treiberstufenleistung in Abhängigkeit vom abgeschalteten Strom,

Fig. 5   die Gateverluste beim Abschalten in Abhängigkeit vom abgeschalteten Strom bei nicht abgesenkter Treiberspannung,

Fig. 6   die Gateverluste beim Abschalten in Abhängigkeit vom abgeschalteten Strom bei abgesenkter Treiberspannung,

Fig. 7   den Leistungsfluß in einer GTO-Treiberstufe,

EP 0 320 784 B1

| Fig. 8 | den zeitlichen Verlauf der Gate-Kathodenspannung bei einstufiger Treiberspannungsabsenkung, |
| Fig. 9 | den zeitlichen Verlauf der Gate-Kathodenspannung bei mehrstufiger Treiberspannungsabsenkung, |
| Fig. 10 | eine Anordnung zur stufenlosen Treiberspannungsabsenkung |
| Fig. 11 | eine Variante zur Anordnung nach Fig. 10. |

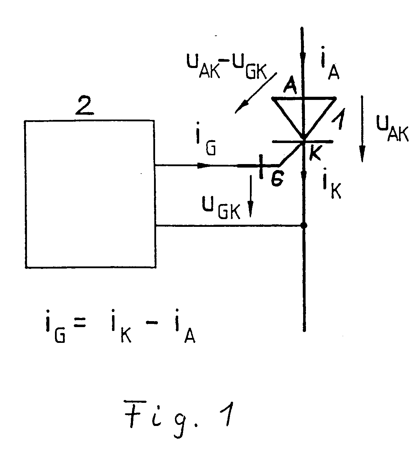

In Fig. 1 ist die Zusammensetzung des Gatestromes beim Abschalten dargestellt. Es ist ein Abschaltthyristor (GTO-Thyristor, GTO) 1 mit Anode A, Kathode K und Gate G sowie eine mit Gate G und Kathode K verbundene Treiberstufe (GTO-Treiberstufe, Gate-Unit, Ansteuereinheit) 2 zu erkennen. Der in die Anode A fließende Anodenstrom ist mit iA, der aus der Kathode K fließende Kathodenstrom ist mit iK und der in das Gate fließende Gatestrom ist mit iG bezeichnet. Es gilt EG = iK - iA. Die zwischen Gate G und Kathode K anliegende Gate-Kathodenspannung ist mit UGK und die zwischen Anode A und Kathode K anliegende Anoden-Kathodenspannung ist mit UAK bezeichnet. Die Anoden-Gatespannung beträgt UAK - UGK.

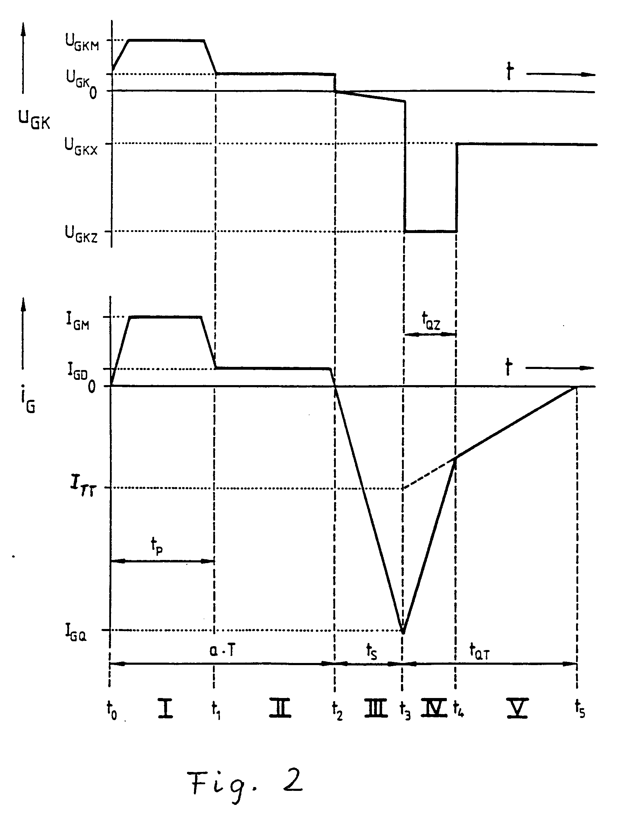

In Fig. 2 sind idealisierte Strom- und Spannungsverläufe am Gate eines GTO dargestellt. Im einzelnen sind im oberen Bildteil der zeitliche Verlauf der Gate-Kathodenspannung UGK und im unteren Bildteil der zeitliche Verlauf des Gatestromes iG gezeigt. Danach gliedert sich der Schaltzyklus eines GTO in fünf Bereiche I....V

Der Zeitraum $t_0 \leq t < t_1$ entspricht der Einschaltphase (= Bereich I): die p-Basis des GTO wird schnell mit vielen Ladungsträgern überschwemmt. Alle Segmente der verteilten Kathodenstruktur werden somit schnell eingeschaltet (UGKM = Maximum der Gate-Kathodenspannung, IGM = Maximum des Gatestromes, tP = Pulszeit).

Der Zeitraum $t_1 \leq t < t_2$ entspricht der Einphase (Gatedauerstrom, Bereich II): Ein Dauerstrom im Gate hält die eingeschalteten Segmente leitend, der GTO bleibt eingeschaltet, schnelle Anodenstromänderungen fügen dem Bauelement keinen Schaden zu (IGD = Dauer-Gatestrom, a = Tastgrad, T = Periodendauer).

Der Zeitraum $t_2 \leq t < t_3$ entspricht der Ausschaltphase (Ausräumen der p-Basis, Bereich III): die überschüssigen Ladungsträger werden durch einen negativen Gatestrom aus der p-Basis entfernt, die Injektion von Ladungsträgern aus dem Kathoden-Emitter wird unterbunden, der GTO schaltet ab, die überschüssigen Ladungsträger aus der n-Basis fließen als Schweifstrom ebenfalls über das Gate ab, der mittlere n-p-Übergang der GTO-Struktur sperrt, die Raumladungszone wird mittels eines Verschiebungsstromes zwischen Anode und Gate aufgebaut (UGKZ = Durchbruch-Anoden-Kathodenspannung, IGQ = Abschalt-Gatestrom, ts = Speicherzeit).

Der Zeitraum $t_3 \leq t$ entspricht der Sperrphase: eine negative Spannung zwischen Gate und Kathode saugt alle auftretenden Ladungsträger auf, die einen ungewollten Einschaltvorgang hervorrufen könnten, schnelle Spannungsänderungen zwischen Anode und Kathode führen nicht zum Zünden (UGKX = Sperr-Gate-Kathodenspannung, tQZ = Durchbruchzeit, d.h. Zeit, während der der GTO im Durchbruch betrieben wird, tQT = Schweifzeit, ITT = Amplitude des "Stromschwanzes").

Im einzelnen erfolgen im Zeitraum $t_3 \leq t < t_4$ (= Bereich IV) der Abbau des überschüssigen Gatestromes im Durchbruchbetrieb und im Zeitraum $t_4 \leq t < t_5$ (= Bereich V) das Ausräumen der n-Basis und der Aufbau der Raumladungszone ("Stromschwanzzeit").

Zur verbesserten Nutzung des Abschaltthyristors wird die negative Treiberspannung zum Zeitpunt $t_3$ (= nach Abfall des Anodenstromes = nach Beendigung der Speicherzeit) auf einen kleineren Wert abgesenkt. Die negative Treiberspannung weist beispielsweise bis zum Zeitpunkt $t_3$ 15V und ab dem Zeitpunkt $t_3$ einen Wert im Bereich 4...7V, vorzugsweise 5V auf.

Bei der Absenkung ist zu beachten, daß die Differenz zwischen der Durchbruchspannung von z.B. 15...25V und der abgesenkten Treiberspannung (Bereich 4...7V) möglichst groß gewählt wird, um die Zielvorgabe, eine verbesserte Nutzung des Abschalttbyristors und der Treiberstufe zu gewährleisten (d.h. Verringerung der in Wärme umgewandelten Verlustleistung), optimal zu erreichen.

Aufgrund der Absenkung der Treiberspannung ab dem Zeitpunkt $t_3$ ist der Wert der negativen Treiberspannung im Bereich III nicht mehr auf Werte unterhalb von üblicherweise 20V beschränkt, sondern kann Frei gewählt werden.

Die Ermittlung des korrekten Umschaltzeitpunktes $t_3$ für die Spannungsabsenkung erfolgt z.B. durch Erfassung der Gate-Kathodenspannung UGK. Das Kriterium ist der Abfall der Gate-Kathodenspannung auf den Wert UGKZ zum Zeitpunkt $t_3$.

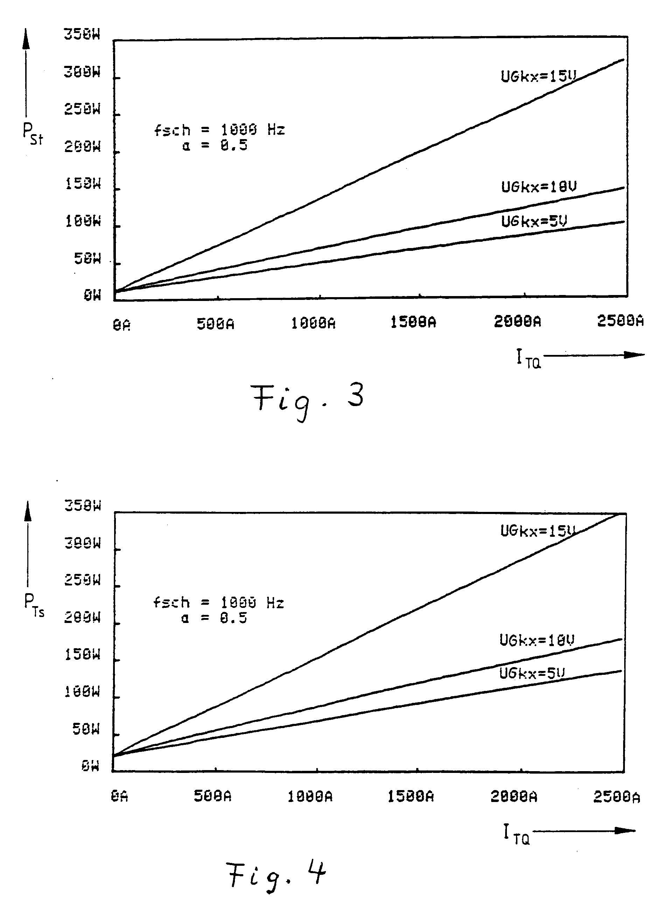

In Fig. 3 ist der Steuerleistungsbedarf in Abhängigkeit vom abgeschalteten Strom dargestellt (PSt = Gatesteuerleistung, ITQ = Abschaltstrom, fsch = Schaltfrequenz). Die Steuerleistung PSt beschreibt den Leistungsbedarf, der seitens des GTO gefordert wird, um den gewünschten Betrieb durchzuführen. Sie stellt einen idealen Grenzfall für die Treiberstufenleistung PTs dar. Diese ist dann im wesentlichen eine auslegungsabhängige Größe unter Berücksichtigung der Treiberstufenverluste. Da bei Hochleistungs-GTOs

3

der Hauptleistungsbedarf durch die hohen negativen Gateströme verursacht wird, ist die negative Spannung, die nach dem Zeitpunkt $t_3$ zwischen Gate und Kathode liegt, in Fig. 3 variiert. Es sind drei Kennlinien für UGKX = 5V, 10V, 15V gezeigt. Dabei ist zu erkennen, daß die Gatesteuerleistung PSt mit kleiner werdender Spannung UGKX beträchtlich sinkt. Bei ITQ = 2000A, z.B. von PSt = 250W bei UGKX = 15V auf PSt = 90W bei UGKX = 5V.

Es ist insgesamt klar zu erkennen, daß durch das schnellere Abmagnetisieren deutlich weniger Gatesteuerleistung benötigt wird, wenn zum Zeitpunkt $t_3$ die vorstehend erwähnte Spannungsumschaltung vorgenommen wird. Unter Vernachlässigung des Gate-Bahnwiderstandes RG gilt im Bereich IV

$$P_{St\,IV} = \frac{1}{T} \cdot U_{GKZ} \cdot I_{GQ} \cdot t_{QZ} \cdot (1 - t_{QZ} \cdot \frac{U_{GKZ} - U_{GKX}}{2 \cdot L_G \cdot I_{GQ}})$$

(LG = Gate-Induktivität, vom Schaltkreis abhängig) und im Bereich V

$$P_{St\,V} = \frac{1}{T} \cdot U_{GKX} \cdot I_{TT} \cdot \frac{(t_{QT} - t_{QZ})^2}{2 \cdot t_{QT}}$$

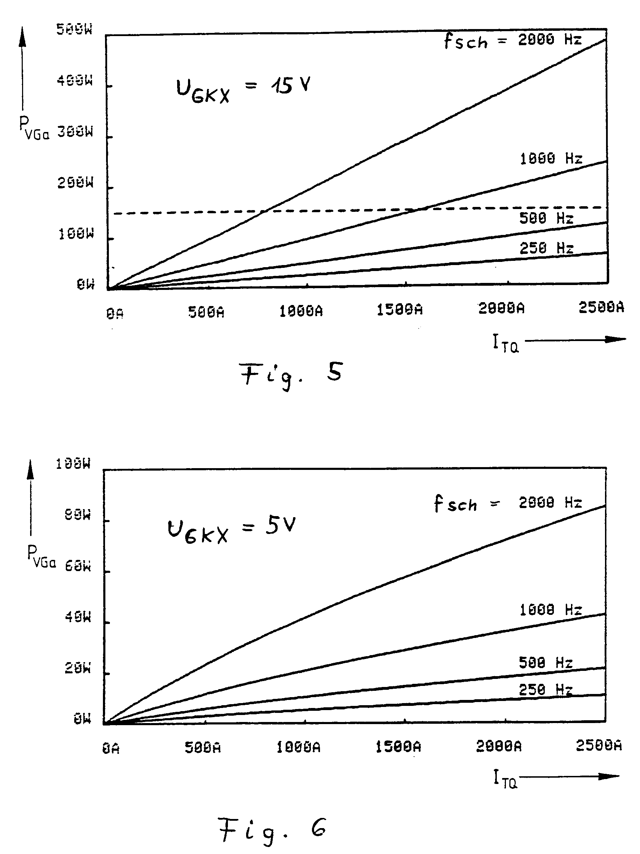

In Fig. 4 ist die Treiberstufenleistung PTs in Abhängigkeit vom abgeschalteten Strom dargestellt. Es sind wiederum drei Kennlinien für UGKX = 5V, 10V, 15V gezeigt. Die Unterschiede zur Steuerleistung gemäß Fig. 3 sind nur sehr gering, was auf den großen Leistungsbedarf beim Abschalten des GTO im Vergleich zu den Treiberstufenverlusten zurückzuführen ist. Im Bereich IV gilt

$$P_{TS\,IV} = \frac{1}{T} \cdot U_{GKX} \cdot I_{GQ} \cdot t_{QZ} (1 - t_{QZ} \frac{U_{GKZ} - U_{GKX}}{2 \cdot L_G \cdot I_{GQ}})$$

Im Bereich V gilt

$$P_{TS\,V} = \frac{1}{T} \cdot U_{GKX} \cdot I_{TT} (\frac{t_{QT}}{2} - t_{QZ})$$

In Fig. 5 sind die Gateverluste beim Abschalten in Abhängigkeit vom abgeschalteten Strom bei nicht abgesenkter Treiberspannung (UGKX = 15V) dargestellt. Es sind vier Kennlinien für fsch = 250Hz, 500Hz, 1000Hz, 2000Hz gezeigt (PVGa = Gateverlustleistung beim Abschalten, PVGe = Gateverlustleistung beim Einschalten). Beachtenswert sind die Werte der Verlustleistung PVGa bei höheren Schaltfrequenzen. Wenn man davon ausgeht, daß nur eine bestimmte maximale Verlustleistung aus dem GTO abgeführt werden kann, die für das betrachtete Beispiel bei ungefähr 700W liegt, dann nehmen die Gateverluste davon schon einen erheblichen Teil in Anspruch. Außerdem wird für weite Betriebsbereiche die zulässige maximale Gateverlustleistung überschritten. Die zulässige maximale Gateverlustleistung ist als gestrichelter Grenzwert eingetragen.

In Fig. 6 sind die Gateverluste beim Abschalten in Abhängigkeit vom abgeschalteten Strom bei abgesenkter Treiberspannung (UGKX = 5V) dargestellt. Durch die Ausschaltung mit reduzierter negativer Steuerspannung (Treiberspannung) sinken die Gateverluste PVGa deutlich unter die angegebenen Grenzwerte (gestrichelt in Fig. 5 eingezeichnet).

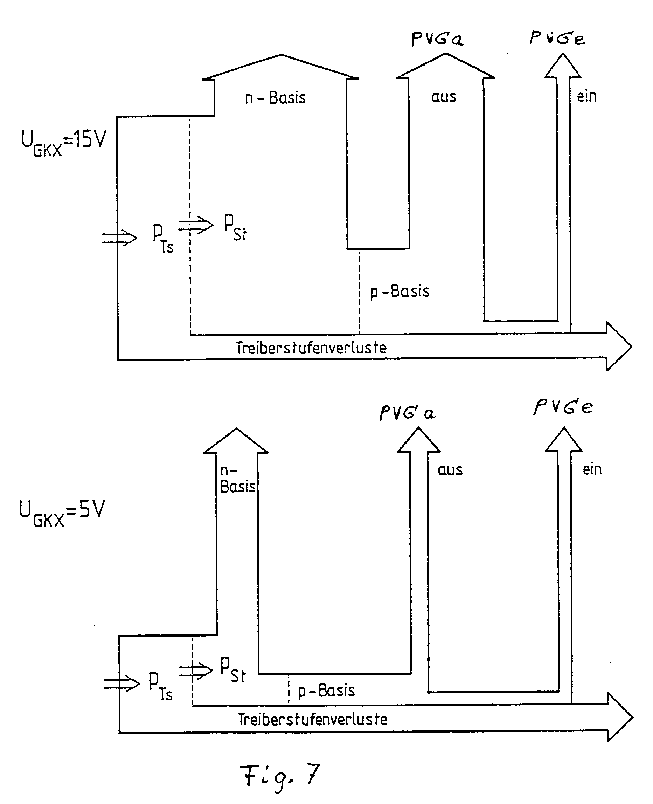

In Fig. 7 ist der Leistungsfluß in einer GTO-Treiberstufe 2 dargestellt (maßstäbliche Darstellung für einen mittleren Betriebspunkt a = 0,5, ITQ = 1250A, fsch = 1000Hz). Im oberen Bildteil der Fig. 7 ist UGKX = 15V angenommen, d.h. es erfolgt keine Absenkung der Treiberspannung. Die aufzuwendende Treiberstufenleistung PTs wird nur zu 35% für die eigentlichen Schaltvorgänge (PVGe und PVGa) verwendet. 55% von PTs werden in der n-Basis des GTO in Verlustwärme umgesetzt. Der Rest von 10% wird auf der Treiberstufe in Wärme umgesetzt ( = Treiberstufenverluste).

Im unteren Bildteil der Fig. 7 ist die Spannung UGKX nach Beendigung der Speicherzeit zum Zeitpunkt $t_3$ auf UGKX = 5V reduziert worden. Die Maßstäbe für beide Bildteile sind gleich. Die Aufwendungen für das Einschalten (PVGe), für die Einphase und für die Verluste auf der Treiberstufe (Treiberstufenverluste) bleiben unverändert. Die Einsparung der Verlustleistung geschieht in beiden Basen des GTOs beim Abschalten. Die Aufteilung der Abschaltverluste in solche der n-Basis und solche der p-Basis kann aus Fig. 1 entnommen werden. Während der "Stromschwanzzeit" entstehen in der n-Basis Verluste wegen iA und UAK - UGK. In der Zeit, der Kathodenstrom iK fließt, entstehen Verluste in der p-Basis wegen UGK = UGKZ und iK.

Die Maßnahme, die negative Versorgungsspannung der Treiberstufe nach Erreichen des Zeitpunktes $t_3$ von 15V auf 5V zu reduzieren, verringert nicht nur den Leistungsbedarf der Treiberstufe, sondern sie vermeidet insbesondere, daß dieser Leistungsmehrbedarf unnötig im GTO in Wärme umgesetzt wird. Für Hochleistungs-GTOs ist sie daher sehr vorteilhaft.

Bei einer einstufigen Absenkung der negativen Treiberspannung auf einen kleineren Wert ist die Gefahr gegeben, daß in dem u. a. aus Gate-Kapazität (im nF-Bereich) und Gate-Induktivität (einige 100 nH) gebildeten Schwingkreis Schwingungen (parasitäre Schwingungen) angeregt werden, die den GTO-Thyristor gefährden.

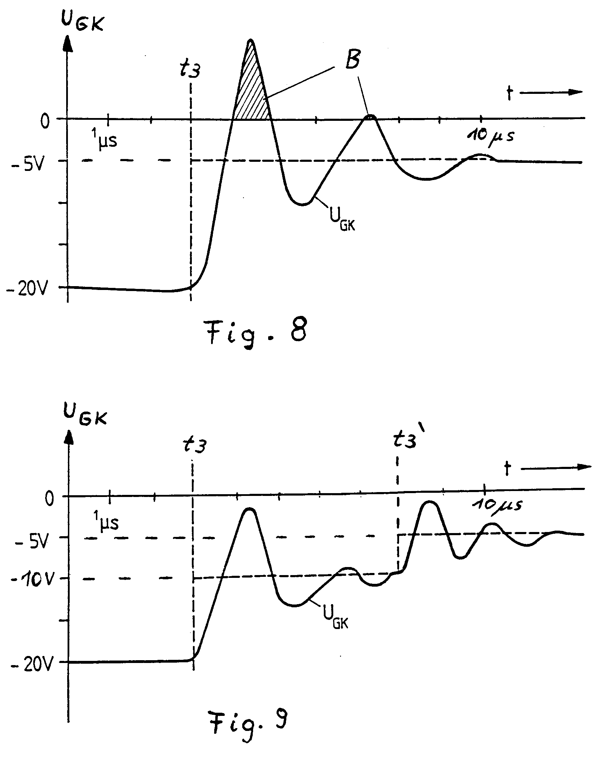

In Fig. 8 ist hierzu der zeitliche Verlauf der Gate-Kathodenspannung UGK bei einstufiger Treiberspannungsabsenkung dargestellt. Zum Zeitpunkt $t_3$ wird die Treiberspannung von -20V auf -5V abgesenkt. Die sich nachfolgend ausbildenden Schwingungen von UGK gefährden den GTO-Thyristor in den mit B bezeichneten schraffierten Bereichen.

Zur Vermeidung derartiger gefährlicher Schwingungen wird die negative Treiberspannung vorteilhaft nicht in einer einzigen, sondern in mehreren Stufen umgeschaltet. Die Anzahl der Stufen richtet sich dabei nach der anfänglich eingestellten ersten Spannung. Jede Stufe sollte die vorhergehende Stufe nur auf höchstens den halben Wert herabsetzen, um die Anregung unvermeidbarer Oszillation in ihrer Auswirkung unschädlich zu halten.

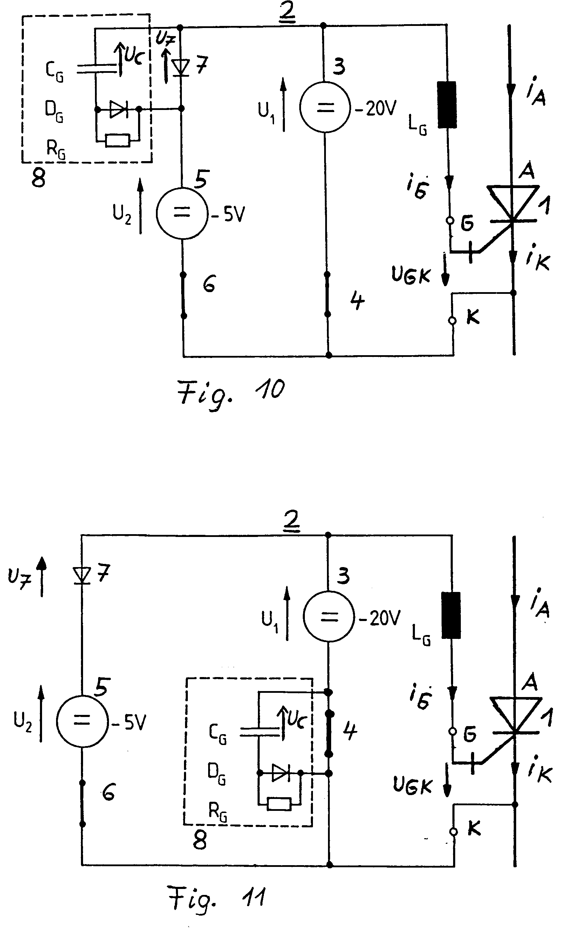

In Fig. 9 ist hierzu der zeitliche Verlauf der Gate-Kathodenspannung UGK bei mehrstufiger Treiberspannungsabsenkung dargestellt. Zum Zeitpunkt $t_3$ wird die Treiberspannung von -20V auf -10V abgesenkt. Die sich nachfolgend ausbildenden Schwingungen von UGK gefährden den GTO-Thyristor nicht mehr. Zum Zeitpunkt $t_3'$ erfolgt eine weitere Absenkung der Treiberspannung von -10V auf -5V. Die sich daraufhin ausbildenden weiteren Schwingungen von UGK gefährden den GTO-Thyristor ebenfalls nicht. Die Zeitspanne zwischen den Umschaltungen (Zeit zwischen $t_3$ und $t_3'$) sollten wenige Periodendauern der parasitären Schwingungen betragen, d.h. etwa 3 bis 7$\mu$s. Die letzte Stufe der negativen Treiberspannung sollte etwa -5V sein.

Anstelle einer mehrstufigen Absenkung der Treiberspannung ist auch eine "stufenlose" Umschaltung nach einer verzögernden Zeitfunktion einsetzbar. Fig. 10 zeigt hierzu eine Anordnung zur stufenlosen Treiberspannungsabsenkung. Es ist der Abschaltthyristor 1 mit Gate-Induktivität LG und Treiberstufe 2 zu erkennen. Die Treiberstufe 2 enthält eine Spannungsquelle 3 mit einer festen Spannung U1 (z.B. U1 = -20V), die über einen Schalter 4 zwischen Gate G und Kathode K des Abschaltthyristors 1 gelegt werden kann. Eine weitere Spannungsquelle 5 mit einer festen Spannung U2 (z.B. U2 = -5V) kann über einen Schalter 6 und eine Diode 7 ebenfalls zwischen Gate G und Kathode K des Abschaltthyristors 1 gelegt werden. Zu der Diode 7 ist die Reihenschaltung eines Kondensators CG mit einer Diode DG parallel geschaltet. Der Diode DC liegt ein Widerstand RG parallel. Die aus Kondensator CG, Diode DG und Widerstand RG bestehende Anordnung ist mit Ziffer 8 bezeichnet.

Bei geschlossenen Schaltern 4 und 6 wird der Kondensator CG über die Diode DG auf eine Spannung UC = U7 (U7 = Spannung an Diode 7) aufgeladen, während gleichzeitig die Spannung U1 als negative Treiberspannung am Abschaltthyristor anliegt. Die stufenlose Absenkung der negativen Treiberspannung wird durch Öffnen des Schalters 4 eingeleitet. Direkt nach dem Öffnen des Schalters 4 liegt die der Spannung U1 entsprechende Spannungssumme U2 + UC (= U1) am Abschaltthyristor an. Anschließend entlädt sich der Kondensator CG über den Widerstand RG und die am Abschaltthyristor anstehende negative Treiberspannung ( = Spannungssumme U2 + UC) sinkt stufenlos bis auf den Wert U2 (= -5V) ab. Die stufenlose Absenkung der negativen Treiberspannung hat den Vorteil, daß keine den Abschaltthyristor gefährdenden parasitären Schwingungen mehr erzeugt werden.

In Fig. 11 ist eine Variante zur Anordnung gemäß Fig. 10 dargestellt. Bei dieser Variante ist die aus Kondensator CG Diode DG und Widerstand RG bestehende Anordnung 8 nicht parallel zur Diode 7, sondern parallel zum Schalter 4 geschaltet. Bei geschlossenen Schaltern 4 und 6 liegt die Spannung U1 als negative Treiberspannung am Abschaltthyristor. Die stufenlose Absenkung der negativen Treiberspannung wird durch Öffnen des Schalters 4 eingeleitet. Der Kondensator CG wird aufgeladen, wodurch die am Abschaltthyristor anstehende negative Treiberspannung stufenlos bis auf den Wert U2 absinkt.

**Patentansprüche**

1. Verfahren zur Ansteuerung eines Abschaltthyristors (1), wobei der Abschaltvorgang durch Einprägen eines negativen Gatestromes (iG) erfolgt und der Absolutbetrag der negativen Treiberspannung (UGKX) vom einem ersten, größeren auf einen zweiten, kleineren Wert abgesenkt wird, sobald der Anodenstrom (iA) abgefallen ist, dadurch gekennzeichnet, daß der Absolutbetrag der negativen Treiberspannung (UGKX) stufenlos nach einer verzögernden Zeitfunktion abgesenkt wird, indem einer die zweite, kleinere negative Treiberspannung (UGKX) erzeugenden Spannungsquelle (5) eine erste Diode (7) in Serie gelegt wird, wobei dieser ersten Diode (7) die Reihenschaltung eines Kondensators (CG) mit einer zweiten Diode (DG) parallelgeschaltet wird und ein Widerstand (RG) parallel zur zweiten Diode (DG) gelegt wird.

2. Verfahren zur Ansteuerung eines Abschaltthyristors (1), wobei der Abschaltvorgang durch Einprägen eines negativen Gatestromes (iG) erfolgt und der Absolutbetrag der negativen Treiberspannung (UGKX) von einem ersten, größeren auf einen zweiten, kleineren Wert abgesenkt wird, sobald der Anodenstrom (iA) abgefallen ist, dadurch gekennzeichnet, daß der Absolutbetrag der negativen Treiberspannung (UGKX) stufenlos nach einer verzögernden Zeitfunktion abgesenkt wird, in dem einer die erste, größere, negative Treiberspannung (UGKX) erzeugenden Spannungsquelle (3) ein Schalter (4) in Serie gelegt wird, dem die Reihenschaltung eines Kondensators (CG) mit einer Diode (DG) parallelgeschaltet wird, wobei ein Widerstand (RG) parallel zur Diode (DG) gelegt wird.

3. Anordnung zur Ansteuerung eines Abschaltthyristors (1), wobei zwei Spannungsquellen (3,5) mit fester Spannung vorgesehen sind, die über Schalter (4,6) zwischen Gate (G) und Kathode (K) des Abschaltthyristors (1) legbar sind, wobei der Abschaltvorgang durch Einprägen eines negativen Gatestromes (iG) erfolgt und der Absolutbetrag der negativen Treiberspannung (UGKX) von einem ersten, größeren auf einen zweiten kleineren Wert abgesenkt wird, sobald der Anodenstrom (iA) abgefallen ist, dadurch gekennzeichnet, daß der die zweite, kleinere, negative Treiberspannung (UGKX) erzeugenden Spannungsquelle (5) eine erste Diode (7) in Serie liegt, wobei dieser ersten Diode (7) die Reihenschaltung eines Kondensators (CG) mit einer zweiten Diode (DG) parallelgeschaltet ist und ein Widerstand (RG) parallel zur zweiten Diode (DG) liegt, wodurch der Absolutbetrag der negativen Treiberspannung (UGKX) stufenlos nach einer verzögernden Zeitfunktion abgesenkt wird.

4. Anordnung zur Ansteuerung eines Abschaltthyristors (1), wobei zwei Spannungsquellen (3,5) mit fester Spannung vorgesehen sind, die über Schalter (4,6) zwischen Gate (G) und Kathode (K) des Abschaltthyristors (1) legbar sind, wobei der Abschaltvorgang durch Einprägen eines negativen Gatestromes (iG) erfolgt und der Absolutbetrag der negativen Treiberspannung (UGKX) von einem ersten, größeren auf einen zweiten kleineren Wert abgesenkt wird, sobald der Anodenstrom (iA) abgefallen ist, dadurch gekennzeichnet, daß der die erste, größere, negative Treiberspannung (UGKX) erzeugenden Spannungsquelle (3) ein Schalter (4) in Serie liegt, dem die Reihenschaltung eines Kondensators (CG) mit einer Diode (DG) parallelgeschaltet ist, wobei ein Widerstand (RG) parallel zur Diode (DG) liegt, wodurch der Absolutbetrag der negativen Treiberspannung (UGKX) stufenlos nach einer verzögernden Zeitfunktion abgesenkt wird.

**Claims**

1. Method for driving a gate turn-off thyristor (1), the turn-off operation being performed by impressing a negative gate current (iG) and the absolute value of the negative driver voltage (UGKX [sic]) being reduced from a first, larger value to a second, smaller value as soon as the anode current (iA) has dropped, characterized in that the absolute value of the negative driver voltage (UGKX [sic]) is reduced continuously in accordance with a delaying time function by connecting a first diode (7) in series with a voltage source (5) which generates the second, smaller negative driver voltage (UGKX [sic]), this first diode (7) being connected in parallel with the series circuit of a capacitor (CG) with a second diode (DG), and a resistor (RG) being connected in parallel with the second diode (DG).

2. Method for driving a gate turn-off thyristor (1), the turn-off operation being performed by impressing a negative gate current (iG) and the absolute value of the negative driver voltage (UGKX [sic]) being reduced from a first, larger value to a second, smaller value as soon as the anode current (iA) has dropped, characterized in that the absolute value of the negative driver voltage (UGKX [sic]) is reduced continuously in accordance with a delaying time function by connecting in series with a voltage source (3) which generates the first, larger, negative driver voltage (UGKX [sic]) a switch (4) which is connected in parallel with the series circuit of a capacitor (CG) with a diode (DG), a resistor (RG) being connected in parallel with the diode (DG).

3. Arrangement for driving a gate turn-off thyristor (1), two voltage sources (3,5) of fixed voltage being provided which can be connected between the gate (G) and cathode (K) of the gate turn-off thyristor (1) via switches (4,6), the turn-off operation being performed by impressing a negative gate current (iG) and the absolute value of the negative driver voltage (UGKX [sic]) being reduced from a first, larger value to a second, smaller value as soon as the anode current (iA) has dropped, characterized in that a first diode (7) is connected in series with the voltage source (5) which generates the second, smaller, negative driver voltage (UGKX [sic]), this first diode (7) being connected in parallel with the series circuit of a capacitor (CG) with a second diode (DG), and a resistor (RG) being connected in parallel with the second diode (DG), as a result of which the absolute value of the negative driver voltage (UGKX [sic]) is reduced continuously in accordance with a delaying time function.

4. Arrangement for driving a gate turn-off thyristor (1), two voltage sources (3,5) of fixed voltage being provided which can be connected between the gate (G) and cathode (K) of the gate turn-off thyristor (1) via switches (4,6), the turn-off operation being performed by impressing a negative gate current (iG) and the absolute value of the negative driver voltage (UGKX [sic]) being reduced from a first, larger value to a second, smaller value as soon as the anode current (iA) has dropped, characterized in that the voltage source (3) which generates the first, larger negative driver voltage (UGKX [sic]), is connected in series with a switch (4) which is connected in parallel with the series circuit of a capacitor (CG) with a diode (DG), a resistor (RG) being connected in parallel with the diode (DG), as a result of which the absolute value of the negative driver voltage (UGKX [sic]) is reduced continuously in accordance with a delaying time function.

**Revendications**

1. Procédé de commande d'un thyristor blocable 1, la commutation à l'état bloquant ayant lieu par application d'un courant de gâchette (iG) négatif et la valeur absolue de la tension d'attaque (UGKX) négative étant abaissée depuis une première valeur relativement élevée à une deuxième valeur plus faible dès que le courant d'anode (iA) a chuté, caractérisé par le fait que l'on abaisse progressivement la valeur absolue de la tension d'attaque (UGKX) négative suivant une fonction de temps de temporisation en branchant une première diode (7) en série avec une source de tension (5) qui produit la deuxième tension d'attaque (UGKX) plus faible, le circuit série formé d'un condensateur (CG) et d'une deuxième diode (DG) étant branché en parallèle avec la première diode (7) et une résistance (RG) étant branchée en parallèle avec la deuxième diode (DG).

2. Procédé de commande d'un thyristor blocable 1, la commutation à l'état bloquant étant obtenue par application d'un courant de gâchette (iG) négatif et la valeur absolue de la tension d'attaque négative (UGKX) étant abaissée d'une première valeur relativement élevée à une deuxième valeur plus faible dès que le courant d'anode (iA) a chuté, caractérisé par le fait que l'on abaisse la valeur absolue de la tension d'attaque (UGKX) de manière progressive suivant une fonction de temps de temporisation en branchant un commutateur (4) en série avec une source de tension (3) qui produit la tension d'attaque négative (UGKX) le circuit série formé d'un condensateur (CG) et d'une diode (DG) étant branché en parallèle avec le commutateur (4) et une résistance (RG) étant branchée en parallèle avec la diode (DG).

3. Dispositif de commande d'un thyristor blocable (1) dans lequel il est prévu deux sources de tension (3,5) avec une tension fixe qui peuvent être connectées au moyen de commutateurs (4,6) entre la gâchette (G) et la cathode (K) du thyristor blocable, la commutation à l'état bloquant étant obtenue par application d'un courant de gâchette (iG) négatif et la valeur absolue de la tension d'attaque (UGKX) négative étant abaissée à partir d'une première valeur relativement élevée à une deuxième valeur plus faible dès que le courant d'anode (iA) a chutté, caractérisé par le fait qu'unepremière diode (7) est branchée en série avec la source de tension (5) qui produit la deuxième tension d'attaque (UGKX) négative plus faible, le circuit série formé d'un condensateur (CG) et d'une deuxième diode (DG) étant branché en parallèle avec la première diode (7) et une résistance (RG) étant branchée en parallèle avec la deuxième diode (DG), permettant ainsi d'abaisser de manière progressive la valeur absolue de la tension d'attaque (UGKX) négative selon une fonction de temps de temporisation.

4. Dispositif de commande d'un thyristor blocable 1, dans lequel il est prévu deux sources de tension (3,5) à tension fixe qui peuvent être connectées entre la gâchette (G) et la cathode (K) du thyristor blocable (1) par l'intermédiaire de commutateurs (4,6), la commutation à l'état bloquant étant obtenue par application d'un courant de gâchette (iG) négatif et la valeur absolue de la tension d'attaque négative (UGKX) étant abaissée à partir d'une première valeur relativement élevée à une deuxième valeur plus faible dès que le courant d'anode (iA) a chuté, caractérisé par le fait qu'un commutateur (4) est branché en série avec la source de tension (3) qui produit la première tension d'attaque négative plus élevée, le circuit série formé d'un condensateur (CG) et d'une diode (DG) étant branché en parallèle avec le commutateur et une résistance RG) étant branchée en parallèle avec la diode (DG), permettant ainsi d'abaisser de manière progressive, la valeur absolue de la tension d'attaque (UGKX) négative selon une fonction de temps de temporisation.

$$U_{AK} - U_{GK}$$

$$i_A$$

A

$$i_G$$

2

1

$$U_{AK}$$

K

G

$$i_K$$

$$U_{GK}$$

$$i_G = i_K - i_A$$

Fig. 1

Fig. 2

Fig. 3

Fig. 4

11

Fig. 5

Fig. 6

PVG'a    PVG'e

n – Basis    aus    ein

$U_{GKX}$=15V

$P_{Ts}$ ⟹ $P_{St}$

p–Basis

Treiberstufenverluste

PVG'a    PVG'e

n–Basis    aus    ein

$U_{GKX}$=5V

$P_{Ts}$ ⟹ $P_{St}$    p–Basis

Treiberstufenverluste

Fig. 7

Fig. 8

Fig. 9

Fig. 10

Fig. 11